# EUROPÄISCHE PATENTANMELDUNG

(11) **EP 1 116 799 A1**
(43) Veröffentlichungstag der Anmeldung: **18.07.2001**
(21) Anmeldenummer: 00127840.7
(22) Anmeldetag: 19.12.2000
(51) Int. Cl.: C23C 14/06, C23C 28/00

(54) **PVD-Verfahren zur Herstellung einer Beschichtung**

(30) Priorität: 14.01.2000 DE 10001381
(71) Anmelder: HAUZER TECHNO COATING EUROPE BV, 5900 AE Venlo (NL)
(72) Erfinder: Eerden, Michel J.J., 6641 NM Benningen (NL); Hurkmans, Antonius Petrus, Taylorsville NC 28681 (US); van der Kolk, Gerrit Jan, 6026 RG Maarheeze (NL)
(74) Vertreter: Manitz, Finsterwald & Partner Gbr

(57) **Zusammenfassung**

Ein PVD-Verfahren zur Herstellung einer Beschichtung (16,18,20,22,23) auf Gegenständen (12), insbesondere auf Gegenständen, die eine relativ niedrige Temperaturbeständigkeit aufweisen, wie Gegenstände aus Messing, Zink und Kunststoff, einschließlich solche mit galvanischer Beschichtung, wobei zur Herstellung einer gefärbten, gegenüber Fingerabdrücken unempfindlichen Beschichtung mehrere Schichten (16,18,20,22) durch Bogenentladungsverdampfung aufgebaut und ausgewählt werden, um allein durch diese Art der Beschichtung eine Farbe zu erreichen, welche der gewünschten Endfarbe soweit wie möglich entspricht und daß mittels Kathoden- bzw. Magnetronzerstäubung oder durch die gleichzeitige Anwendung von Bogenentladungsverdampfung und Kathoden- bzw. Magnetronzerstäubung eine Hartstoff-Deckschicht (23) auf den Schichtaufbau aufgebracht wird, die die endgültige Farbgebung erzeugt und auf die kleinstmögliche Schichtdicke, vorzugsweise auf unter 500 nm begrenzt wird.

## Beschreibung

Die vorliegende Erfindung betrifft ein PVD-Verfahren zur Herstellung einer gefärbten, gegenüber Fingerabdrücken weniger empfindlichen Beschichtung auf Gegenständen nach dem Oberbegriff von Anspruch 1 sowie Gegenstände mit einer solchen Beschichtung.

Ein PVD-Verfahren zur Beschichtung von Gegenständen ist beispielsweise dem europäischen Patent 439 561 bzw. der entsprechenden europäischen Anmeldung 909 09 697 zu entnehmen. Diese Schrift beschreibt ein PVD-Verfahren, bei dem die zu beschichtenden Gegenstände in einer zur Durchführung von sowohl Bogenentladungsverdampfung als auch Kathoden- bzw. Magnetronzerstäubung ausgelegten PVD-Anlage eingeführt und zunächst durch eine im Bogenentladungsmodus erzeugte Ionenätzung gereinigt und geätzt werden, eine Verankerungsschicht mittels Bogenentladungsverdampfung auf den Gegenstand aufgebaut wird und danach eine weitere Beschichtung mittels Kathoden- bzw. Magnetronzerstäubung durchgeführt wird.

Ein ähnliches Verfahren ist in der europäischen Anmeldung 99183848.8 beschrieben, wobei diese Anmeldung sich mit der Erzeugung von Mehrlagenhartstoffschichten für Korrosionsbeständigkeit und Abriebfestigkeit befaßt.

Es ist bekannt, vor allem auf dem Gebiet von Baubeschlägen und Handelswaren für den allgemeinen Gebrauch, dekorative Beschichtungen mittels solcher PVD-Verfahren auf verschiedenen Materialien anzubringen, wobei die Beschichtungen auch für harte und korrosionsbeständige Oberflächen sorgen sollen. Die typischen Gegenstände, die in Frage kommen, bestehen aus Messing, Zink und Kunststoffen, häufig mit galvanisierten Oberflächen. Solche Materialien haben eine verhältnismäßig niedrige Temperaturbeständigkeit und müssen daher bei relativ niedrigen Temperaturen beschichtet werden.

Problematisch bei der dekorativen Beschichtung von Gegenständen der oben genannten Art mittels PVD-Verfahren ist die Fingerabdruckempfindlichkeit der hergestellten Beschichtungen. Fett von den Fingern der Benutzer neigt dazu, in die Beschichtung einzudringen, wodurch die Fingerabdrücke sichtbar werden. Die so entstehenden Fingerabdrücke sind auch schwierig zu entfernen, da die fettigen Substanzen, die die Fingerabdrücke sichtbar machen, nicht nur auf der Beschichtung, sondern innerhalb der Beschichtung sich befinden.

Es ist nämlich bekannt, daß bei Durchführung der bekannten Art von PVD-Sputter-Beschichtungen bei niedrigen Temperaturen offene, säulenartige Beschichtungsstrukturen entstehen, die, so vermutet man, deshalb vorkommen, weil die sich auf der Oberfläche des Gegenstandes kondensierenden Materialien hauptsächlich neutrale Atome sind. Die offenen, säulenartigen Strukturen bevorzugen den Eingang der fettigen Substanzen zwischen den Säulen. Weiterhin bietet die offene, säulenartige Struktur mehr Angriffsfläche für einen chemischen Angriff auf die Gegenstände durch chemische Verbindungen, die in der Umgebung vorhanden sind und durch zur Reinigung eingesetzte Substanzen.

Für dekorative Farben, die durch PVD-Beschichtungen hergestellt werden, kann es auch vorkommen, daß die gewünschte Farbe am besten durch Kathoden- bzw. Magnetronzerstäubung erreicht werden kann.

Aufgabe der vorliegenden Erfindung ist es, ein PVD-Verfahren zur Herstellung einer gefärbten, gegenüber Fingerabdrücken unempfindlichen Beschichtung auf Gegenständen vorzusehen, insbesondere auf solchen Gegenständen, die eine relativ niedrige Temperaturbeständigkeit aufweisen, wie Gegenstände aus Messing, Zink und Kunststoff, bei dem man einerseits die gewünschte Farbe erreicht andererseits aber auch die gewünschte Unempfindlichkeit gegenüber Fingerabdrücken sicherstellt.

Um die oben genannte Aufgabe zu lösen, wird erfindungsgemäß ein Verfahren vorgesehen zur Herstellung einer Beschichtung auf Gegenständen, insbesondere auf Gegenständen, die eine relativ niedrige Temperaturbeständigkeit aufweisen, wie Gegenstände aus Messing, Zink und Kunststoff, einschließlich solche mit galvanischer Beschichtung, wobei die zu beschichtenden Gegenstände in einer zur Durchführung von sowohl Bogenentlagungsverdampfung als auch Kathoden- bzw. Magnetronzerstäubung ausgelegten PVD-Anlage eingeführt und zunächst durch eine im Bogenentladungsmodus oder durch eine Plasmaquelle erzeugte Ionenätzung gereinigt und geätzt werden, eine Verankerungsschicht mittels Bogenentladungsverdampfung auf den Gegenstand aufgebaut wird und danach eine weitere Beschichtung mittels Kathoden- bzw. Magnetronzerstäubung durchgeführt wird, wobei zur Herstellung einer gefärbten, gegenüber Fingerabdrücken unempfindlichen Beschichtung mehrere Schichten durch Bogenentladungsverdampfung aufgebaut und ausgewählt werden, um allein durch diese Art der Beschichtung eine Farbe zu erreichen, welche der gewünschten Endfarbe soweit wie möglich entspricht und daß mittels Kathoden- bzw. Magnetronzerstäubung oder durch die gleichzeitige Anwendung von Bogenentladungsverdampfung und Kathoden- bzw. Magnetronzerstäubung eine Hartstoff-Deckschicht auf den Schichtaufbau aufgebracht wird, die die endgültige Farbgebung erzeugt und auf die kleinstmögliche Schichtdicke, vorzugsweise auf unter 500 nm begrenzt wird.

Während beim Stand der Technik die gewünschte Farbe durch Kathoden- bzw. Magnetronzerstäubung erreicht wird und Bogenentladungsverdampfung entsprechend der EP-B-0 439 561 oder der europäischen Anmeldung 99 183 848.8, ist es erfindungsgemäß festgestellt worden, daß die Beschichtung der Gegenstände mittels Bogenentladungsverdampfung zu Beschichtungen führt, die beim vergleichbaren Temperaturniveau eine höhere Dichte aufweisen, wodurch das Entstehen von offenen, säulenartigen Strukturen weitgehend unterbunden wird, was auf den ionisierten Zustand der sich kondensierenden Stoffströme zurückzuführen ist. Dadurch, daß die Beschichtung eine erhöhte Dichte aufweist, ist das Problem der Fingerabdruckempfindlichkeit wesentlich geringer. Es entsteht zwar weiterhin eine säulenartige Struktur, die Kernbilding der säulenartigen Struktur im Bogenentladungsverdampfungsmodus führt jedoch zu mehr Säulen mit kleinerem Durchmesser und einer eher geschlossenen Form. Die im Bogenentladungsverdampfungsmodus erzeugte Struktur wird im Zerstäubungsmodus beibehalten.

Bei den bekannten Verfahren dagegen wird der Bogenentladungsmodus nur zur Erzeugung der Verankerungsschicht benutzt, die weitere Beschichtung wird mittels Kathoden- bzw. Magnetronzerstäubung durchgeführt.

Es ist auch erfindungsgemäß festgestellt worden, daß trotz dieser geänderten Verfahrensweise, die gewünschte Farbgebung in beinahe allen Fällen erreicht werden kann, wenn man einerseits die entsprechenden Elemente für den Schichtaufbau mittels Bogenentladungsverdampfung wählt und Magnetronzerstäubung nur für den Aufbau der letzten Schicht benutzt, die auch entsprechend dünn ausgebildet werden kann und üblicherweise unter 100 nm Dicke liegt. Bei dieser dünnen Schicht, die in manchen Fällen auch durch kombinierte Magnetronzerstäubung und Bogenentladungsverdampfung hergestellt werden kann (und somit dichter ist als durch Magnetronzerstäubung alleine), ist das Problem der Fingerabdrücke nicht sehr ausgeprägt und eventuell entstehende Fingerabdrücke lassen sich noch mit entsprechenden Reinigungsmitteln entfernen.

Besonders günstig ist es, wenn der Zerstäubungsschritt in Anwesenheit von Argon durchgeführt wird, da die so entstehenden Ar+-Ionen, die die Oberfläche der Beschichtung beschießen, zu einer Verdichtung der freien Oberfläche der Beschichtung führen, wodurch die Empfindlichkeit gegenüber Fingerabdrücken weiter herabgesetzt wird.

Auch ist erfindungsgemäß festgestellt worden, daß das erfindungsgemäße Verfahren sich besonders zur Erzielung der von der BHMA (Building Hardware Manufacturers' Association, USA) definierten Farbe "braun" eignet, die bisher mittels PVD-Verfahren nicht realisierbar war. Diese Farbe "braun" ist mit der Beschreibung "oil rubbed dark bronze" umschrieben und von der BHMA mit der Nummer 613 gekennzeichnet.

Wenn man diese Farbe mit dem Verfahren, das in CIE Colorimetry, 2. Ausgabe, veröffentlicht am 15.2.1996, mißt, wobei dieses Verfahren entsprechend den Vorschriften gemäß ISO 7724/1 (1984) "Paints and Varnishes", Colorimetry, Teil 1: Principles, oder ASTM E 308 (1985) Standard Method for Computing the Colours of Objects by Using the CIE System oder ASTM D 2244 (1985) Standard Method for Calculation of Colour Differences from Instrumentally Measured Colour Coordinates, oder
DIN 5033 (1980): Farbmessung, Farbmaßzahlen, auszuführen ist, so erhält man folgende L*, a* und b*-Werte für BHMA 613:
L* = 45 +/- 3
a^{*} = 5 +/- 1,5 und
b^{*} = 12 +/- 3.

Diese Werte wurden mit einem Minolta CM-2002 Spektrophotometer mit folgenden Einstellungen gemessen:
Beleuchtungsmittel: D65
Beobachtungsbedingung: 10°
spiegelnde Komponente eingeschlossen.

Diese Farbe kann jedoch erfindungsgemäß dadurch realisiert werden, daß eine Zr-Schicht und dann durch Einführung von Kohlenstoff (C) und Stickstoff (N) in die Atmosphäre der Behandlungskammer eine ZrCN-Schicht mittels Bogenentladungsverdampfung auf den Gegenstand aufgebaut werden, wobei anschließend eine TiAlZrN-Schicht zur Erzeugung der gewünschten Endfarbe mittels Kathoden- bzw. Magnetronzerstäubung als Deckschicht aufgebracht wird.

Besonders bevorzugt wird das Verfahren so durchgeführt, daß mehrere Lagen aus Zr und ZrCN abwechselnd auf die Gegenstände aufgebracht werden vor Anbringung der Deckschicht. Alle Lagen können ca. 0,1 µm dick sein

Weiterhin betrifft die Erfindung gefärbte, fingerabdruckunempfindliche mittels PVD beschichtete Gegenstände, die in den weiteren Patentansprüchen näher definiert sind.

Bevorzugte Ausführungsformen der Erfindung lassen sich den Patentansprüchen entnehmen.

Die Erfindung wird nachfolgend näher erläutert anhand eines Ausführungsbeispiels unter Bezugnahme auf die Zeichnung, in welcher zeigen:
- Fig. 1: ein Beispiel für den Schichtaufbau einer erfindungsgemäßen Beschichtung, um die BHMA-Farbe 613 zu erzeugen,
- Fig. 2: eine für die Durchführung des erfindungsgemäßen Verfahrens besonders geeignete Beschichtungsanlage in schematischer Darstellung,
- Fig. 3 und Fig. 4: unterschiedliche Beispiele für die Erzeugung der Farbe Schwarz.

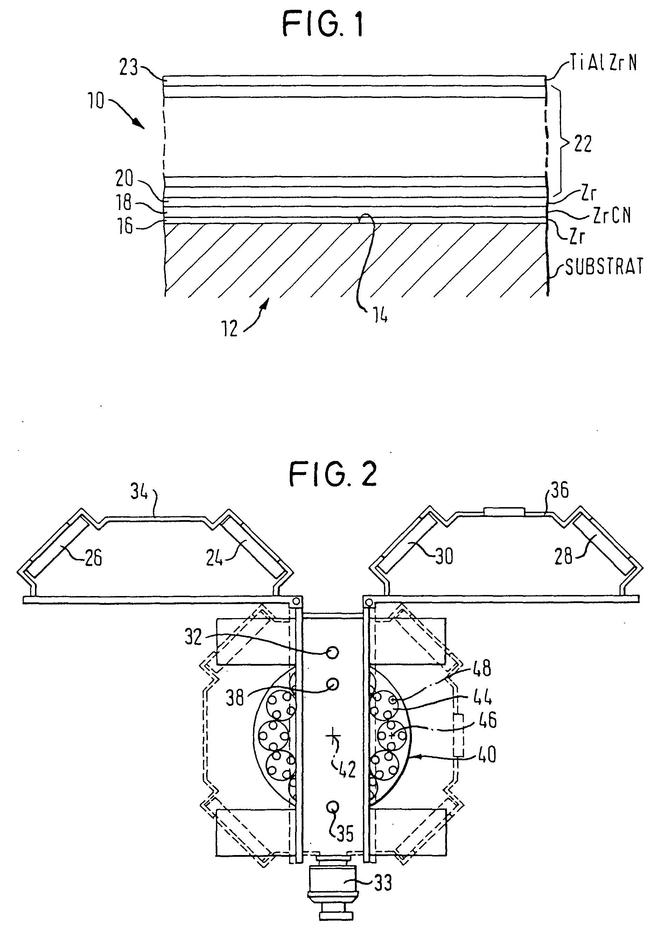

Fig. 1 zeigt in schematischer Weise ein Beispiel einer erfindungsgemäßen Beschichtung aus abwechselnden Schichtfolgen 10 zur Schaffung der BHMA-Farbe "braun" auf einem Substrat 12. Die Beschichtung in Form der Schichtfolge 10 kann auf einem beliebigem Substrat 12 aufgebracht werden.

In diesem Beispiel befindet sich auf der mittels eines Ionenätzverfahrens unter Anwendung von Zr-Ionen geätzten Oberfläche 14 des Substrats eine Übergangsschicht 16 aus Zr mit einer Dicke im Bereich von etwa 0,1 µm.

Alternativ zum Ionenätzen mittels Zr-Ionen könnte das Ionenätzen mit Ar⁺-Ionen durchgeführt werden.

Auf der dem Substrat 12 abgewandten Oberfläche der Übergangsschicht 16 befindet sich eine Schicht 18 aus ZrCN mit einer Dicke von etwa 0,05µm.

Dieser ZrCN-Schicht 18 folgt eine weitere Zr-Schicht 20, danach abwechselnd mehrere weitere ZrCN- und Zr-Schichten 22, wobei in diesem Beispiel ca. 10-30 einzelne Schichten vorgesehen sind, die üblicherweise etwa 0,05µm dick sind, wobei die oberste Schicht eine ZrCN-Schicht ist, die mit Vorteil etwas dicker sein kann, bspw.0,1µm. Die Gesamtzahl der abwechselnden Zr-/ZrCN-Schichten ist nicht kritisch.

Auf der obersten ZrCN-Schicht 18 befindet sich eine Deckschicht 23 aus TiAlZrN von 0,1 bis 0,5 µm Dicke. Während die Schichten 16, 18, 20 und die weiteren Schichten der abwechselnden Schichtfolge 22 mittels Bogenentladungsverdampfung hergestellt werden, wird die obere Deckschicht 23 durch Magnetronzerstäubung erzeugt. Wie diese Schichten hergestellt werden, wird nunmehr in Bezug auf Figur 2 näher erläutert.

Anstatt mehrere abwechselnde Schichten von Zr und ZrCN zu verwenden, könnte man nur eine Schicht Zr auf dem Substrat anbringen (ca. 0,1 µm oder dicker) und darauf eine einzige Schicht von ZrCN (zwischen 0,1 µm und 1 µm, üblicherweise etwa 0,3 bis 0,5 µm dick) aufbauen, wobei diese beiden Schichten mittels Bogenentladungsverdampfung hergestellt werden. Wie bei der Mehrschichtanordnung wird dann als Deckschicht eine TiAlZrN-Schicht von 0,1 bis 0,5 µm Dicke mittels Magnetronzerstäubung auf die ZrCN-Schicht aufgebracht. Auch hierdurch entsteht die gewünschte Farbe "braun", d.h. BHMA 613.

Fig. 2 zeigt eine bevorzugte, zur Durchführung des erfindungsgemäßen Verfahrens verwendbare Beschichtungsanlage.

Diese Anlage ist strichliert im geschlossenen Zustand und mit ausgezogenen Linien mit geöffneten bzw. aufgesperrten Kammertüren dargestellt. Die hier gezeigte Anlage, die im Prinzip nach dem europäischen Patent 0 439 561 aufgebaut ist und betrieben wird, umfaßt vier Targets 24, 26, 28 und 30, wobei die Targets 24 und 26 in einer aufschwenkbaren Kammerwand 34 und die Targets 28 und 30 in der anderen aufschwenkbaren Kammerwand 36 gehalten sind.

Es handelt sich jeweils um Rechteck-Targets, die sich bezogen auf die Zeichnung vertikal erstrecken und entweder im Bogenentladungsmodus oder als unbalancierte Magnetrons zur Durchführung eines Kathoden-Zerstäubungs-Verfahrens betrieben werden.

Das Bezugszeichen 34 deutet auf eine Turbomolekularpumpe hin, die zur Evakuierung der Behandlungskammer im geschlossen Zustand dient.

Das Bezugszeichen 36 zeigt in schematischer Form eine Zuführung für Schutzgas wie Argon, während die Zuführung 38 der Einführung von dem in diesem Beispiel benötigten Stickstoff dient. Azetylen (C2H2) kann über eine weitere Zuführung 32 in die Behandlungskammer eingeführt werden.

Fig. 2 zeigt außerdem einen Substratträger 40, der einerseits um eine zentrale Achse 42 rotiert, und andererseits Substrathalter 44 aufweist, die wiederum um ihre jeweilige Achse 46 rotieren, so daß durch den Vorbeilauf der Substrate bzw. Gegenstände vor den verschiedenen Targets die jeweils gewünschte Schichtbildung erfolgen kann.

In diesem Beispiel bestehen die Targets 24, 26 und 28 aus Zr, während das Target 30 aus TiAl besteht.

Bei dem nachfolgend zu beschreibenden Verfahren werden die Targets 26 und 30 jeweils als unbalancierter Magnetron betrieben, während die Targets 24, 28 und 32 im Bogenentladungsmodus betrieben werden können.

Nach der Anbringung der zu beschichtenden Substrate auf die Substrathalter 40 und das Schließen der Behandlungskammer, die durch Verschwenkung der beiden Türen aus der in Fig. 2 in durchgehenden Linien gezeigten Stellung in die strichlierte Stellung erreicht wird, wird die Kammer über die Turbomolekularpumpe 34 evakuiert und Argon zur Bildung der Kammeratmosphäre über die Zuführung 36 in die Behandlungskammer eingespeist.

Während dieses Verfahrens oder kurz danach wird aufgeheizt, bis die Gegenstände 14 eine Temperatur von unter 200°C erreicht haben. Danach wird durch die Anbringung geeigneter Spannungen an einem oder beiden der Targets 24 und 28 und am Substratträger 40 bzw. an die Substrathalter 44 in an sich bekannter Weise für die Erzeugung von Zr-Ionen und Ar-Ionen und hierdurch für das Ionenätzen und -reinigen der Oberflächen der Gegenstände 12 gesorgt. Während dieses Behandlungsschrittes dreht sich der Substratträger 40 um die Achse 42. Die Substrathalter 44 drehen sich um die eigene jeweilige Achse 46, wobei, falls gewünscht, die einzelnen Gegenstände 12 auch um ihre eigene Längsachse 48 gedreht werden können.

Auf diese Weise werden alle zu beschichtenden Oberflächen der Gegenstände 12, beispielsweise Türbeschläge oder Griffe von Wasserhähnen, zumindest im wesentlichen gleichmäßig mit Zr- und/oder Ar-Ionen geätzt und hierdurch gereinigt.

Nach Abschluß des Ätzverfahrens werden die Targets 24 und 28 aus Zr weiter benutzt, und zwar im Bogenentladungsmodus, um die Übergangsschicht 16 zu erzeugen. Nach Erzeugung der Schicht 16 aus Zr wird Stickstoff N2 mit ein wenig Azetylen, beispielsweise 10 % Massestrom, über die Zuführungen 32 und 38 der Atmosphäre der Behandlungskammer zugeführt, wodurch die erste ZrCN-Schicht 18 im Bogenentladungsmodus entsteht.

Nach Herstellung der Schicht 18 aus ZrCN wird die Zufuhr von Stickstoff über die Zuführung 38 und die Zufuhr von Azetylen über die Zuführung 32 gestoppt und Argon über die Zuführung 36 der Kammeratmosphäre erneut zugeführt. Durch den weiteren Betrieb der Targets 24 und 28 im Bogenentladungsmodus wird die Schicht 20 aus Zr hergestellt. Durch Betrieb des Targets 32 im Bogenentladungsmodus und Gaswechsel auf Stickstoff und Azetylen über die Zuführungen 38 und 32 wird eine weitere Schicht aus ZrCN auf die Schicht 20 aufgebaut und durch Wiederholung des Verfahrens schließlich die gesamte abwechselnde Schichtfolge 22. Alle diese Schichten werden daher im Bogenentladungsmodus hergestellt. Nach Abschluß der Schichtfolge 22 wird nunmehr das Target 30 aus TiAl und das Target 26 aus Zr in Betrieb genommen, und zwar zur Durchführung von Kathodenzerstäubung, d.h. die Targets 30 und 26 werden als unbalancierte Magnetrons betrieben. Gleichzeitig wird Stickstoff der Atmosphäre der Behandlungskammer über die Zuführung 38 zugeführt, wodurch die Deckschicht 23 aus TiAlZrN mit ebenfalls 0,1 bis 0,5 µm Dikke auf der freien Oberfläche der Schichtfolge 22 aufgebaut wird. Die Beschichtung, d.h. der Gegenstand 12 weist nunmehr eine harte, für Fingerabdrücke unempfindliche, vorzugsweise auch korrosionsbeständige Oberfläche mit der gewünschten Farbe braun auf.

Dadurch, daß die Substrate 12 auf die Substrathalter 44 an den Substrathalter 40 durch die Ionenströme der Targets hindurchpassieren und die Gegenstände 12 um die eigene Achse 48, um die Achse 46 der Substrathalter 44 und um die Achse des Substratträgers 40 gedreht werden, erfolgt eine gleichmäßige Beschichtung aller wesentlichen Oberflächen der zu beschichtenden Gegenstände, so daß auch die Farbgebung gleichmäßig und einheitlich gestaltet ist. D.h. die Drehbewegungen der Gegenstände werden für alle Reinigungs- und Beschichtungsvorgänge aufrechterhalten.

Nach Herstellung der Deckschicht 23 sind die Gegenstände 12 fertig beschichtet und können aus der Behandlungskammer entnommen und der weiteren Verwendung zugeführt werden.

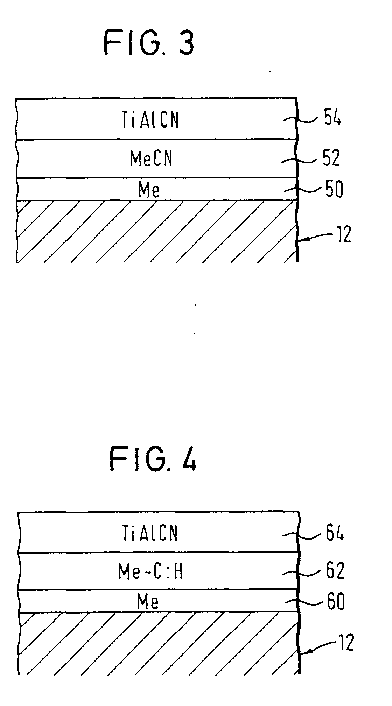

Die Fig. 3 und 4 zeigen alternative Möglichkeiten zur Erzeugung der Farbe schwarz. Für diese Farbe können folgende CIE L^{*}-, a^{*}- und b^{*}-Werte angegeben werden:
a^{*} = 0
b^{*}=0
L^{*} = 20-70.

Gemäß Fig. 3 wird diese Farbe wie folgt auf ein Substrat 12 erzeugt:

Als erstes wird eine Metallschicht 50 aus einem beliebigen Metall, das üblicherweise für PVD-Verfahren benutzt wird, erzeugt, beispielsweise eine Schicht aus Pi, Cr, Zr oder W, und zwar mit einer Dicke von üblicherweise 0,1 µm, wobei auch dickere Schichten möglich sind, beispielsweise bis zu 1 µm, was aber nicht notwendig ist. Diese Metallschicht wird durch Bogenentladungsverdampfung erzeugt. Auf diese Metallschicht wird dann eine Schicht 52 aus MeCN abgelagert, wobei Me für ein Metall steht, üblicherweise das gleiche Metall, das für die Schicht 50 benutzt wird. Auch diese Schicht 52 wird durch Bogenentladungsverdampfung erzeugt und ist üblicherweise im Bereich zwischen 0,1 µm und 1 µm, üblicherweise 0,3 µm, dick. Es leuchtet ein, daß die Metallschicht 50 mit einem Inertgas, beispielsweise Argon, in der Behandlungskammer abgelagert wird und daß zur Erzeugung der MeCN-Schicht Stickstoff und Azetylen der Gasatmosphäre der Kammer zugeführt wird.

Anschließend wird eine Deckschicht 54 aus TiAlCN mittels Magnetronzerstäubung auf die Schicht 52 abgelagert, mit einer Dicke von bis zu 1 µm, üblicherweise 500 nm oder kleiner. Hierdurch entsteht die gewünschte Farbe schwarz, wie oben definiert.

Als Alternative zur Ablagerung einer einzelnen Schicht 50 aus Metall und einer einzelnen Zwischenschicht 52 aus MeCN kann, wie beim Beispiel gemäß Fig. 1, eine Schichtfolge aus abwechselnden Schichten von Metall und MeCN benutzt werden, wobei die einzelnen Schichten dann dünner sind und wie bisher eine Schichtfolge von insgesamt 10-30 einzelnen Schichten benutzt wird.

Das Beispiel gemäß Fig. 4 wird wie folgt realisiert:

Als erstes wird auf das Substrat 12 auch hier eine Metallschicht 60 mittels Bogenverdampfung abgelagert, ebenfalls mit einer Dicke von üblicherweise 0,1 µm, wobei die Schichtdicke auch größer als 0,1 µm sein kann, beispielsweise bis zu etwa 1 µm dick. Auch hier kann das Metall aus einem beliebigen Metall bestehen, das üblicherweise für PVD-Verfahren verwendet wird, beispielsweise aus Ti, Cr, Zr oder W.

Danach wird die Schicht 62 unter Anwendung des gleichen Metalls unter Anwendung des Bogenverdampfungsverfahrens auf die Schicht 60 abgelagert, wobei dieses Verfahren mit einem relativ hohen Anteil von C₂H₂ in der Kammeratmosphäre durchgeführt wird, so daß ein Metallkarbid mit eingebautem Wasserstoff entsteht, was durch die Bezeichnung Me-C:H zum Ausdruck gebracht wird. Diese Schicht 62 ist, wie beim Beispiel in Fig. 3, üblicherweise im Bereich zwischen 0,1 µm und 1 µm dick, insbesondere etwa 0,3 µm dick. Nach Ablagerung der Schicht 62 wird die Deckschicht 64 aus TiAlCN mittels Magnetronzerstäubung abgelagert. Diese Schicht ist hier identisch zur Schicht 54 des Beispiels in Fig. 3. Es gelten zu dieser Schicht die gleichen Angaben, die im Zusammenhang mit der Schicht 54 gemacht wurden.

Auch bei diesem Beispiel kann anstelle einer einzigen Metallschicht 60 und einer einzigen Me-C:H-Schicht 62 eine Schichtfolge aus 10-30 abwechselnden einzelnen Schichten abgelagert werden, wobei die einzelnen Schichten dann dünner werden, beispielsweise 0,05 µm dick, wobei die erste und die letzte Schicht der Schichtfolge mit Vorteil etwas dicker sein können, bspw. 0,1µm.

Bei allen Beispielen kann es sich bei dem Substrat 12 um ein temperaturempfindliches Substrat handeln. In allen Fällen wird der Vorteil erreicht, daß die Beschichtung nicht nur die gewünschte Farbe aufweist und widerstandsfähig ist, sondern auch gegen Fingerabdrücke unempfindlich ist. In allen Beispielen gemäß den Fig. 3 und 4 wird die Farbe schwarz erzeugt, wie oben definiert.

## Patentansprüche

1. PVD-Verfahren zur Herstellung einer Beschichtung (16,18,20,22,23; 50,52,54; 60,62,64) auf Gegenständen (12), insbesondere auf Gegenständen, die eine relativ niedrige Temperaturbeständigkeit aufweisen, wie Gegenstände aus Messing, Zink und Kunststoff, einschließlich solche mit galvanischer Beschichtung, wobei die zu beschichtenden Gegenstände in einer zur Durchführung von sowohl Bogenentlagungsverdampfung als auch Kathoden- bzw. Magnetronzerstäubung ausgelegten PVD-Anlage (Fig. 2) eingeführt und zunächst durch eine im Bogenentladungsmodus oder durch eine Plasmaquelle erzeugte Ionenätzung gereinigt und geätzt werden, eine Verankerungsschicht (16; 50; 60) mittels Bogenentladungsverdampfung auf den Gegenstand aufgebaut wird und danach eine weitere Beschichtung (23; 54; 64) mittels Kathoden- bzw. Magnetronzerstäubung durchgeführt wird,
**dadurch gekennzeichnet**,
daß zur Herstellung einer gefärbten, gegenüber Fingerabdrücken unempfindlichen Beschichtung mehrere Schichten (16,18,20,22; 50,52; 60,62) durch Bogenentladungsverdampfung aufgebaut und vorzugsweise ausgewählt werden, um allein durch diese Art der Beschichtung eine Farbe zu erreichen, welche der gewünschten Endfarbe soweit wie möglich entspricht und daß mittels Kathoden- bzw. Magnetronzerstäubung oder durch die gleichzeitige Anwendung von Bogenentladungsverdampfung und Kathoden- bzw. Magnetronzerstäubung eine Hartstoff-Deckschicht (23; 54; 64) auf den Schichtaufbau aufgebracht wird, die die endgültige Farbgebung erzeugt und auf die kleinstmögliche Schichtdicke, vorzugsweise auf unter 500 nm begrenzt wird.

2. Verfahren nach Anspruch 1,
**dadurch gekennzeichnet**,
daß der Zerstäubungsschritt in Anwesenheit von Argon durchgeführt wird, um durch den Beschuß mit Ar+-Ionen eine Verdichtung der freien Oberfläche der Beschichtung zu erzielen.

3. Verfahren nach Anspruch 1 oder 2,
**dadurch gekennzeichnet**,
daß zur Erzielung der von der BHMA definierten Farbe "braun" zunächst eine Zr-Schicht (16) und dann durch Einführung von Kohlenstoff (C) und Stickstoff (N) in die Atmosphäre der Behandlungskammer eine ZrCN-Schicht (18) mittels Bogenentladungsverdampfung auf den Gegenstand (12) aufgebaut werden und daß anschließend eine TiAlZrN-Schicht (23) zur Erzeugung der gewünschten Endfarbe mittels Kathoden- bzw. Magnetronzerstäubung als Deckschicht aufgebracht wird.

4. Verfahren nach Anspruch 3,
**dadurch gekennzeichnet**,
daß vor Anbringung der Deckschicht (23) mehrere Lagen (16,18,20,22) aus Zr und ZrCN abwechselnd auf die Gegenstände aufgebracht werden.

5. Verfahren nach Anspruch 4,
**dadurch gekennzeichnet**,
daß alle abwechselnder Lagen bis auf die erste und die letzte ca. 0,05 µm dick sind.

6. Verfahren nach Anspruch 1,
**dadurch gekennzeichnet**,
daß zur Erzielung der Farbe schwarz eine der nachfolgenden Schichtvariationen aufgebracht wird:
a) eine erste Schicht (50) aus einem Metall, das üblicherweise bei PVD-Verfahren benutzt wird, eine zweite Schicht (52) aus MeCN, wobei das Metall (Me) vorzugsweise das gleiche Metall ist, wie für die erste Schicht (50) verwendet wird, und die erste und zweite Schicht durch Bogenentladungsverdampfung erzeugt werden und eine Deckschicht (54) aus TiALCN, die durch Magnetronzerstäubung erzeugt wird,
b) eine Schichtanordnung wie bei a) angegeben, jedoch mit mehreren abwechselnden Schichten aus Metall und MeCN,
c) eine erste Schicht (60) aus einem Metall, das üblicherweise bei PVD-Verfahren benutzt wird, eine zweite Schicht (62) aus Me-C:H, wobei das Metall (Me) vorzugsweise das gleiche Metall ist das für die erste Schicht (60) verwendet wird und diese erste und zweite Schicht (60,62) durch Bogenentladungsverdampfung erzeugt werden und eine Deckschicht (64) aus TiAlCN, die durch Magnetronzerstäubung erzeugt wird, und
d) eine Schichtanordnung wie bei c), jedoch mit mehreren abwechselnden Schichten aus Metall und Me-C;H.

7. Gefärbter, fingerabdruckunempfindlicher, mittels PVD beschichteter Gegenstand (12) bestehend aus einem temperaturempfindlichen Material wie Messing, Zink und Kunststoff, einschließlich ein solches Material mit galvanischer Beschichtung, insbesondere zu dekorativen Zwecken, wie Beschläge für Gebäude oder wasserführende Armaturen, wobei der Gegenstand (12) mindestens zwei durch Bogenentladungsverdampfung erzeugten Schichten (16,18; 50,52; 60,62) und vorzugsweise mehrere solche Schichten aufweist, die vorzugsweise zumindest im wesentlichen der gewünschten Endfarbe ergeben und daß die Endfarbe der Oberfläche des Gegenstands durch eine oberste Deckschicht (23; 54; 64) gebildet ist, welche durch Kathoden- bzw. Magnetronzerstäubung oder durch kombinierte Bogenentladungsverdampfung und Kathoden- bzw. Magnetronzerstäubung erzeugt wird, wobei die Deckschicht die kleinstmögliche Dicke aufweist und vorzugsweise kleiner als 500 nm ist.

8. Gegenstand nach Anspruch 7, in der von der BHMA definierten Farbe 613,
**dadurch gekennzeichnet**,
daß die Beschichtung aus einer Zr-Schicht (16) und mindestens einer ZrCN-Schicht (18), vorzugsweise mehreren abwechselnden Zr und ZrCN-Schichten (16,18,20,22) besteht, die durch Bogenentladungsverdampfung auf den Gegenstand abgelagert sind und daß die Deckschicht (23) aus TiAlZrN besteht und mittels Kathoden- bzw. Magnetronzerstäubung oder mittels Kathoden- bzw. Magnetronzerstäubung in Kombination mit Bogenentladungsverdampfung auf den Gegenstand aufgebracht ist.

9. Gegenstand nach Anspruch 8,
**dadurch gekennzeichnet**,
daß bei mehreren abwechselnden Zr und ZrCN-Schichten (16,18,20,22) alle dieser Lagen bis auf die erste und die letzte ca. 0,05 µm dick sind.

10. Gegenstand nach Anspruch 7,
**dadurch gekennzeichnet,**
daß er die Farbe schwarz aufweist, die durch eine der nachfolgenden Schichtanordnungen realisiert ist:
a) eine erste Schicht (50) aus einem Metall, das üblicherweise bei PVD-Verfahren benutzt wird, eine zweite Schicht (52) aus MeCN, wobei das Metall (Me) vorzugsweise das gleiche Metall ist, das für die erste Schicht (50) verwendet wird, und die erste und zweite Schicht (50,52) durch Bogenentladungsverdampfung erzeugt werden und eine Deckschicht (54) aus TiALCN, die durch Magnetronzerstäubung erzeugt wird,
b) eine Schichtanordnung wie bei a) angegeben, jedoch mit mehre- . ren abwechselnden Schichten aus Metall und MeCN,
c) eine erste Schicht (60) aus einem Metall, das üblicherweise bei PVD-Verfahren benutzt wird, eine zweite Schicht (62) aus Me-C:H, wobei das Metall (Me) vorzugsweise das gleiche Metall ist wie für die erste Schicht (60) verwendet wird und diese erste und zweite Schicht (60,62) durch Bogenentladungsverdampfung erzeugt werden und eine Deckschicht (64) aus TiAlCN, die durch Magnetronzerstäubung erzeugt wird, und
d) eine Schichtanordnung wie bei c), jedoch mit mehreren alternierenden Schichtpaaren aus Metall und Me-C:H.
